Europäisches Patentamt

European Patent Office

Office européen des brevets

(11) Veröffentlichungsnummer: **0 472 843 A1**

# EUROPÄISCHE PATENTANMELDUNG

(21) Anmeldenummer: **91110228.3**

(22) Anmeldetag: **21.06.91**

(51) Int. Cl.5: **H05K 13/00**

(30) Priorität: **20.08.90 DE 4026269 U**

(43) Veröffentlichungstag der Anmeldung:
**04.03.92 Patentblatt 92/10**

(84) Benannte Vertragsstaaten:
**AT BE DE ES FR GB IT NL**

(71) Anmelder: **Stucki Kunststoffwerk und Werkzeugbau GmbH.
Schötmarsche Strasse
W-4902 Bad Salzuflen 1(DE)**

(72) Erfinder: **Korte, Klaus
Falkenweg 7
W-4902 Bad Salzuflen 1(DE)**

(74) Vertreter: **Junius, Walther, Dr.
Wolfstrasse 24
W-3000 Hannover-Waldheim(DE)**

(54) Transport- und Lagervorrichtung für Leiterplatten.

(57) Eine Vorrichtung für den Transport und die Lagerung von Leiterplatten wird so stabil ausgeführt, daß man sie mitsamt den Leiterplatten auf Röllchen- bahnen laufen lassen kann, ohne daß die Vorrichtung oder die Leiterplatten Schaden nehmen.

FIG.2

Die Erfindung betrifft eine Transport- und Lagervorrichtung für Leiterplatten, bestehend aus einem Boden, zwei an diesem angebrachten Seitenwänden, mindestens einem an den Seitenwänden verschieb- und feststellbar angebrachten Zwischenteil und zwischen den Eckbereichen der Seitenwände angeordneten Distanzstangen und/oder Distanzrohren, von denen der Boden und die Zwischenteile auf den einander zugekehrten Seiten mit die Leiterplatten halternden Schienen und auf den den Leiterplatten abgekehrten Seiten mit Verstärkungsrippen versehen sind, wobei die Seitenwände mit Langlöchern parallel zu deren Rändern versehen sind, in denen an den Zwischenteilen angreifende Befestigungsmittel verschieb- und feststellbar sind.

Eine derartige Transport- und Lagervorrichtung für Leiterplatten ist aus der DE-OS 38 01 966.3 bekannt geworden. Mit dieser Vorrichtung werden Leiterplatten sowohl im innerbetrieblichen Transport von Arbeitsplatz zu Arbeitsplatz sicher transportiert als auch im außerbetrieblichen Transport zu Montagebetrieben gebracht. Diese Transport- und Lagervorrichtung hat sich gut bewährt und wird vielfach eingesetzt.

Der innerbetriebliche Transport dieser bekannten Transport- und Lagervorrichtung erfolgt bisher auf Wagen, um die empfindlichen Leiterplatten schonend zu transportieren. Es hat sich jedoch gezeigt, daß auch ein Transport über Transportbänder möglich ist. Denn die Leiterplatten werden oftmals auch in mechanisch erheblich beanspruchten Geräten eingesetzt und erweisen sich hier als stoß- und rüttelfest. Der Einsatz von Transportbändern bringt den Nachteil mit sich, daß diese immer einen motorischen Antrieb erfordern, der das über Rollen laufende Band antreibt, damit die auf das Band gestellten Transportbehälter mitgenommen werden können.

Diesen motorischen Antrieb benötigen Rollen- und Röllchenbahnen nicht, die für den Transport von Flaschenkästen in Brauereien und Getränkeabfüllbetrieben sowie für den Transport von Transportkästen in der Lebensmittelindustrie eingesetzt werden. Gibt man diesen Rollen- oder Röllchenbahnen eine kleine Neigung, so laufen die Transportkästen von allein über diese Bahnen, wenn der Boden dieser Transportkästen unten glatt ist. Derartig glatte Böden sind z.B. bei Holzkisten vorhanden, deren Boden aus einer Platte besteht.

Jedoch auch für Kunststoffkästen, deren Böden aus Gründen der Festigkeit und der Materialersparnis mit Rippen versehen sein müssen, sind Bodenausbildungen für Transportkästen entwickelt worden, die trotz ihrer Versteifungsrippe auf Rollen- und Röllchenbahnen laufen können. Diese Bodenausbildungen sind durch das DE-GM 89 03 430 und das DE-GM 90 02 339 bekannt geworden. Diese Böden zeichnen sich durch einen unteren glatten Randbereich aus, bei dem die Rippen nach außen gerichtete Fächer zwischen der glatten durchgehenden oberen Bodenfläche und der unteren glatten Randfläche einschließen.

Diese Bodenausbildung läßt sich jedoch nicht ohne weiteres an der bekannten Transport- und Lagervorrichtung für Leiterplatten realisieren. Auch ist die Stabilität der bekannten Transport- und Lagervorrichtungen für Leiterplatten nicht ausreichend, um für den rauhen Transport über Rollen- und Röllchenbahnen geeignet zu sein.

Die Erfindung vermeidet die Nachteile des Standes der Technik. Es ist die Aufgabe der Erfindung, eine Transport- und Lagervorrichtung für Leiterplatten in einfacher Weise so zu gestalten, daß sie in beliebiger Lage über Rollen- und Röllchenbahnen transportierbar ist und dabei auch ausreichende Stabilität aufweist.

Die Erfindung besteht darin, daß sowohl die Bodenplatte als auch die Seitenwände mit Verstärkungsrippen versehen sind, die in den Randbereichen nach innen oder zu den Stirnseiten in den Mittenbereichen nach außen gerichtet sind, wodurch die Bodenplatte und die Seitenwände nach außen glatte Randbereiche aufweisen, daß in den Ecken der Seitenwände in den sonst glatten Randbereichen Ausnehmungen angeordnet sind, in denen Befestigungsmittel für die Distanzstangen liegen, und daß die Langlöcher in den Mittenbereichen angeordnet sind, in denen die Rippen nach außen gerichtet sind und die Befestigungsmittel für die Zwischenteile eine geringere Höhe als die nach außen gerichteten Rippen aufweisen.

Durch die Doppelwandigkeit der Seitenwände in den Randbereichen gewinnt die Transport- und Lagervorrichtung erheblich an Stabilität, gleichzeitig wird hierdurch aber auch ermöglicht, daß die Transport- und Lagervorrichtung auf einer ihrer Seitenwände liegend über Rollen- und Röllchenbahnen transportiert werden kann. Alle Befestigungsmittel liegen zwischen den Rippen und stehen nicht über die Seitenebenen der Wände und der Bodenplatte hinaus. Hierdurch wird es möglich, daß die Transport- und Lagervorrichtung einwandfrei über Rollen- und Röllchenbahnen läuft und die hierzu erforderliche hohe Stabilität aufweist.

Diese Stabilität wird weiter dadurch erheblich erhöht, daß die Zwischenteile auf zwei gegenüberliegenden Stirnseiten, mit denen sie an den Seitenwänden anliegen, winkelförmige Ansätze aufweisen, in denen Befestigungsmittel für die Befestigung der Seitenwände untergebracht sind. Durch diese winkelförmigen Ansätze, die zweckmäßigerweise auch noch mit Rippen verstärkt sind, wird eine sehr hohe Stabilität erzielt.

Diese Stabilität wird weiter noch dadurch erhöht, daß in den Seitenwänden parallel zu deren Rändern verlaufende langgestreckte Vertiefungen als Führungsschienen für an den Ansätzen angebildete Vorsprünge ausgebildet sind. Diese Ausführung versteift die Transport- und Lagervorrichtung ganz wesentlich.

Zweckmäßig ist es, wenn in den Vertiefungen kreis- oder rechteckförmige Ausnehmungen für Rastkugeln oder Raststifte angeordnet sind, deren Halter in den winkelförmigen Ansätzen eingebaut sind. Hierdurch wird es ermöglicht, die Zwischenteile auf genaue Abstände zur Bodenplatte einzustellen, was notwendig ist, wenn Leiterplatten unterschiedlicher Dimensionen befördert werden sollen. Diese Rastmöglichkeit erhöht ebenfalls die Stabilität der Transport- und Lagervorrichtung.

Für die Stabilität ist es aber auch erforderlich, daß die Leiterplatten stabil in der Transport- und Lagervorrichtung untergebracht sind und nicht während des Transportes sich verschieben oder gar herausfallen können. Um dieses zu erreichen, ist es zweckmäßig, wenn das Zwischenteil an demjenigen Rand, an dem die Halteschienen für die Leiterplatten nicht durch eine quer verlaufende Halteschiene verschlossen sind, einen um ein Gelenk klappbaren Haltewinkel aufweist, der an seinen Stirnseiten einen rechtwinklig angeformten Ansatz trägt, der ein Gelenkteil haltert.

Hierbei ist es zweckmäßig, wenn der Ansatz an der Halteschiene eine Ausnehmung aufweist, in die in der Haltestellung ein am Zwischenteil befestigter federnder Stift oder ein federnder Winkel einfällt.

Das Wesen der Erfindung ist nachstehend anhand eines in der Zeichnung schematisch dargestellten Ausführungsbeispieles näher erläutert. Es zeigen:

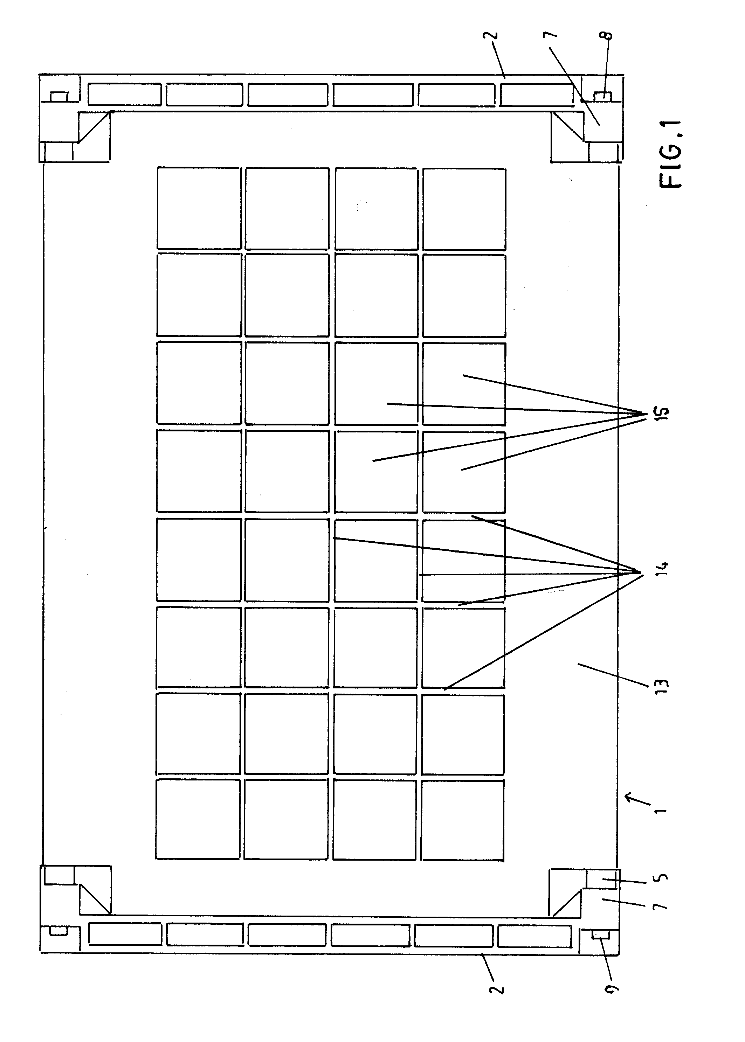

Fig. 1     eine Ansicht der Vorrichtung von unten,

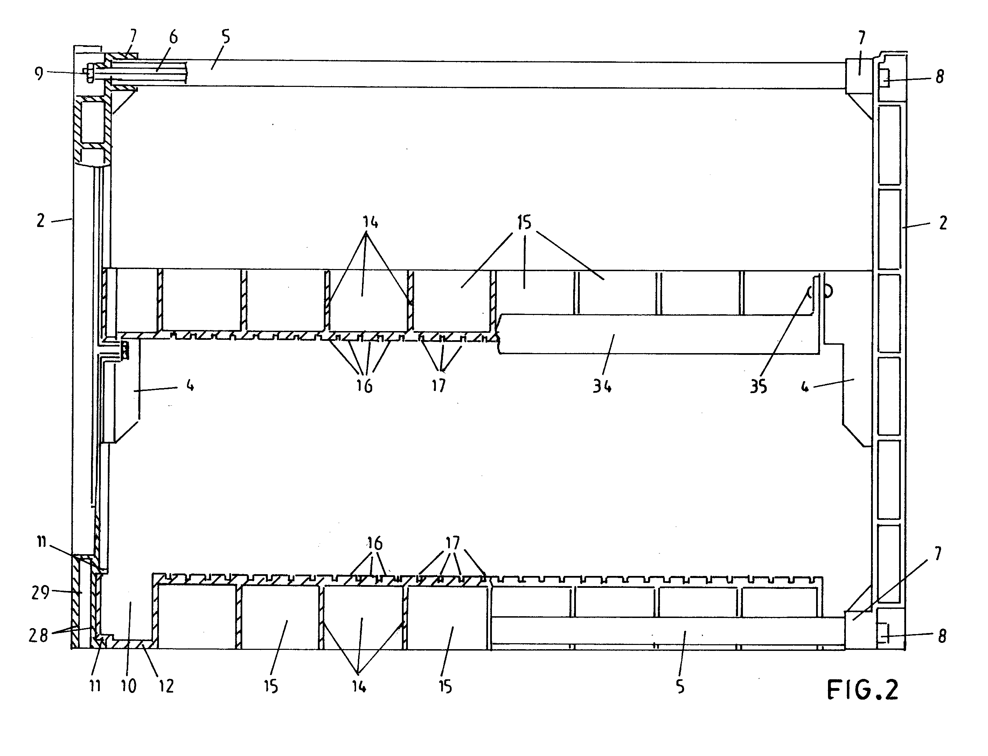

Fig. 2     linke Hälfte: Ein Vertikal schnitt durch die Vorrichtung, rechte Hälfte eine Seitenansicht der Vorrichtung,

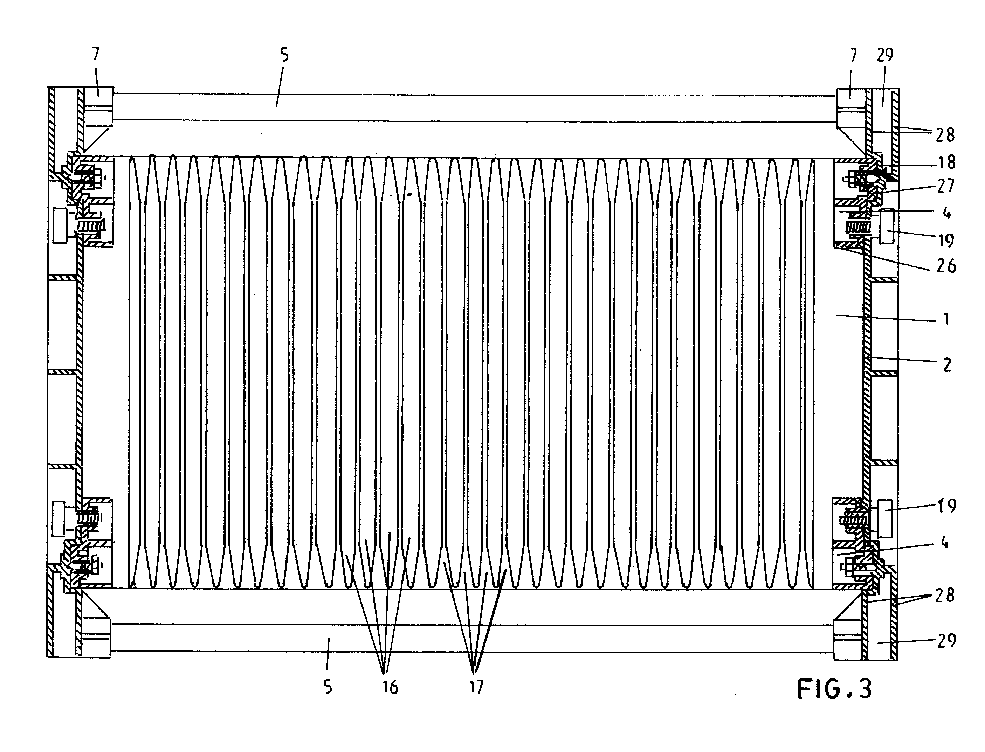

Fig. 3     einen Horizontalschnitt durch die Vorrichtung in Höhe der winkelförmigen Ansätze des Zwischenteils,

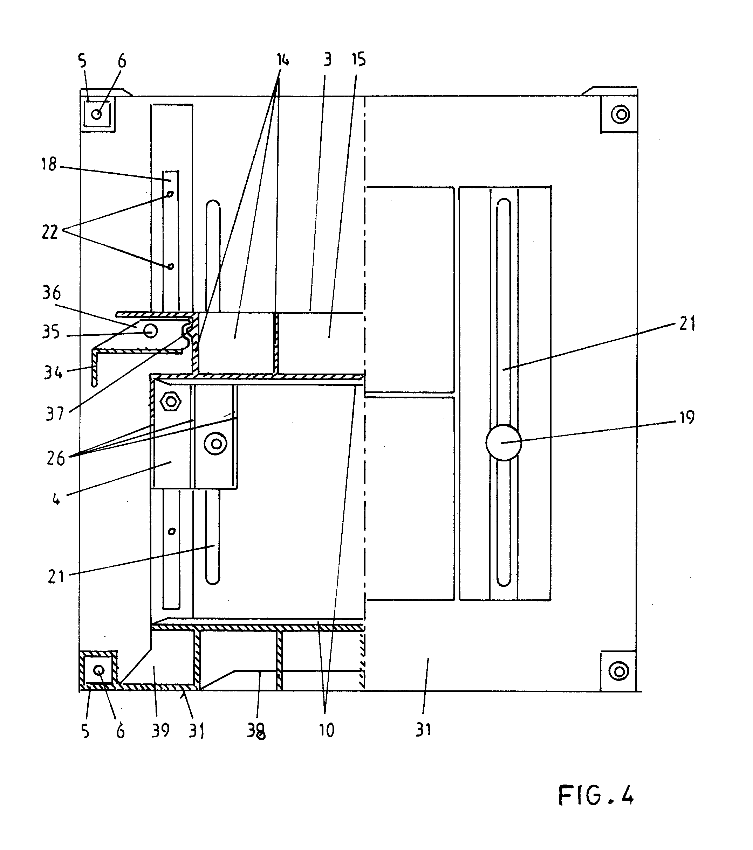

Fig. 4     linke Hälfte: einen Vertikalschnitt durch die vorrichtung rechte Hälfte: eine Frontansicht der Vorrichtung,

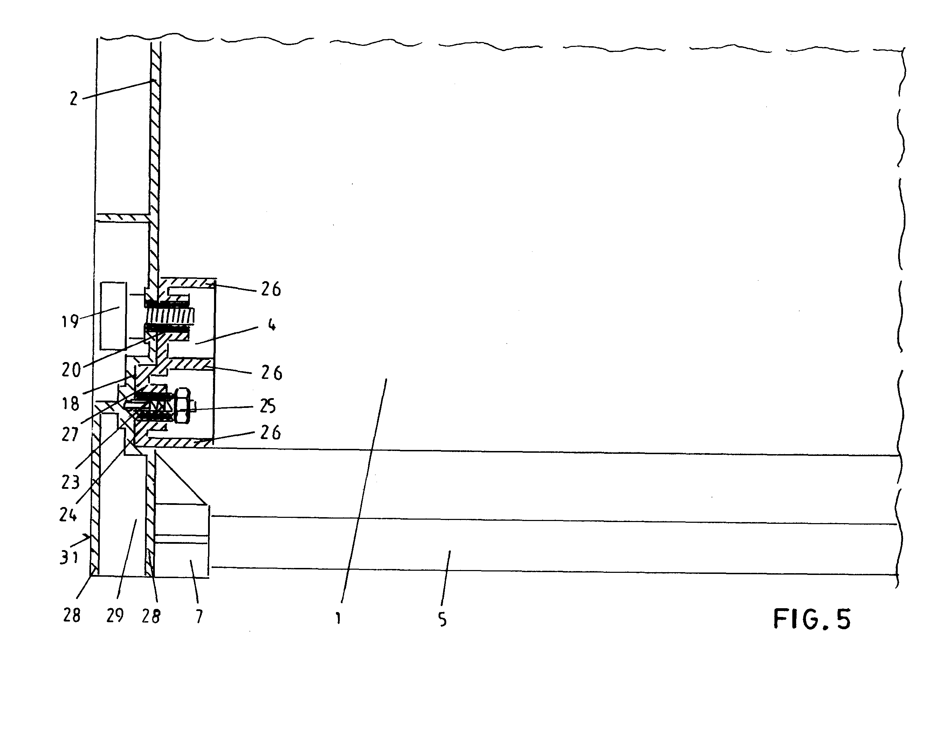

Fig. 5     in Vergrößerung die Befestigung des Zwischenteiles an der Seitenwand.

Die Transport- und Lagervorrichtung für Leiterplatten besteht aus einem Boden 1 , zwei Seitenwänden 2, einem Zwischemteil 3 mit winkelförmigen Ansätzen 4, Distanzrohren 5 und Zugstangen 6. Die beiden Seitenwände 2 weisen rohrförmige Ansätze 7 auf, in welche die Distanzrohre 5 mit ihren Enden eingesteckt sind. Die rohrförmigen Ansätze 7 und die Distanzrohre 5 sind von den Zugstangen 6 durchsetzt, die an ihren Enden einen Kopf 8 und ein Schraubgewinde tragen, auf das die Mutter 9 aufgeschraubt ist. Der Kopf 8 und die Mutter 9 stützen sich auf die äußere Oberfläche der Seitenwände 2 ab. Fest eingespannt zwischen den beiden Seitenwänden 2 ist auf diese Weise der Boden 1, welcher seitlich in ein U-förmiges nach oben offenes Hohlprofil 10 ausmündet, welches zwischen zwei Vorsprüngen 11 an der Seitenwand 2 eingeklemmt ist.

Der von den beiden seitlichen Schenkeln des U-förmigen Hohlprofiles 10 eingeschlossene Mittelschenkel 12 bildet mit seiner nach außen gerichteten Oberfläche den Laufrahmen 13, mit dem der Boden 1 der Transport- und Lagervorrichtung für Leiterplatten auf Röllchenbahnen laufen kann.

Das Mittelfeld im Inneren dieses Laufrahmens ist durch Rippen 14 ausgesteift, die zwischen sich nach außen hin offene Taschen 15 einschließen. Auf der nach innen gerichteten Oberfläche des Mittelfeldes des Bodens 1 befinden sich eine Vielzahl von Führungsschienen 16, die Nuten 17 zwischen sich einschließen, in welche die in der Vorrichtung zu lagernden Leiterplatten mit ihren Außenkanten eingeschoben werden.

Die gleichen Führungsschienen 16 und Nuten 17 befinden sich an der nach innen, dem Boden zu gerichteten Oberfläche des Zwischenteiles 3, während die nach außen gerichtete Oberfläche des Zwischenteiles 3 mit sich kreuzenden Rippen 14 versehen ist, die ebenfalls zwischen sich Taschen 15 einschließen. Dieses Zwischenteil 3 weist winkelförmige Vorsprünge 11 auf, die in in den Seitenwänden 2 eingeformten Führungsschienen 18 verschiebbar und mittels der Feststellschrauben 19 feststellbar ist. Die Feststellschraube 19 ist in eine in den winkelförmigen Ansatz 4 fest eingelassene Mutter 20 eingeschraubt.

Damit das Zwischenteil 3 in seinem Abstand gegenüber dem Boden 2 verstellbar ist, greift die Feststellschraube 19 durch ein in der Seitenwand 2 eingeformtes Langloch 21. Die Führungsschiene 18 ist mit kreisförmigen Aussparungen 22 in Form von Vertiefungen versehen, in welche ein Raststift 23 einfällt, welcher durch eine Feder 24 nach außen gedrückt ist, die unter dem Druck der Schraube 25 steht.

Die winkelförmigen Ansätze 4 sind mit Rippen 26 versehen, welche einstückig mit dem Zwischenteil 3 hergestellt sind und die den winkelförmigen Vorsprüngen 4 einen undeformierbaren Halt an dem Zwischenteil 3 geben.

Dieser feste Halt der winkelförmigen Vorsprünge 4 am Zwischenteil 3, der durch die Rippen 26 erzielt wird, sowie der formschlüssige Sitz des im Querschnitt U-förmigen Vorsprunges 27 in der im Querschnitt U-förmigen Führungsschiene 18 in der Seitenwand 2 sichert die Stabilität der Transport- und Lagervorrichtung für Leiterplatten, die notwendig ist, damit diese Vorrichtung auf Röllchenbahnen laufen kann.

Diese Transport- und Lagervorrichtung für Leiterplatten kann nicht nur mit ihrem Boden auf Röllchenbahnen laufen, sondern auch mit ihren Seitenwänden. Denn die Seitenwände 2 sind in ihren äußeren Bereichen doppelwandig durch zwei Wände 28 aufgebaut, die durch Rippen 29 gegeneinander abgestützt sind, so daß im Randbereich der Seitenwände nach außen offene Taschen 30 und ein Laufrahmen 31 gebildet ist. Dieser Laufrahmen erstreckt sich rings um die äußere Seitenfläche der Seitenwand 2 und weist lediglich Ausnehmungen 32 auf, die dem Einführen von Werkzeugen zum Anziehen der Muttern 9 und zum Einstecken der Zugstangen 6 dienen. Dieser Laufrahmen 31 schließt ein Mittelteil ein, welches nach außen gerichtete Rippen 33 aufweist.

In dieser Transport- und Lagervorrichtung werden die nicht dargestellten Leiterplatten durch einen Haltewinkel 34 gehalten, der um das Lager 35 verschwenkbar ist. Dieses Lager haltert an jedem Ende des Haltewinkels 34, wenn nötig auch in Zwischenbereichen, am Haltewinkel 34 seitlich angebrachte Supporte 36, welche an ihrem rückwärtigen Ende eine Ausnehmung aufweisen, in die ein Vorsprung 37 an der Rippe 14 einfällt, wenn sich der Haltewinkel 34 in der Stellung befindet, in der er die in die Nuten 17 zwischen den Führungsschienen 16 eingeschobenen nicht dargestellten Leiterplatten hält. Dieser Haltewinkel 34 kann nach oben gedrückt und verschwenkt werden, wobei die rückwärtige Ausnehmung im Support 36 vom Vorsprung 37 abspringt, in dem sie den Vorsprung 37 nach hinten hin verschiebt. Dieser Vorsprung 37 kann fest an der Rippe 14 angebracht sein, zweckmäßig ist es jedoch, ihn federnd mit ausreichender Federstärke dort anzubringen.

Damit die Transport- und Lagervorrichtung einwandfrei auf Röllchenbahnen läuft, ist es zweckmäßig, wenn die Rippen 14 sich nicht bis in die Ebene der Laufrahmen 13 und 31 erstrecken, sondern entlang der Linie 38 zurückspringend angeordnet sind.

An den beiden Rändern des Bodens 1 ist ein nach außen und innen offenes Profil ausgebildet, das nach außen und innen offene Taschen 39 bildet. Die Außenseite kann somit einen Teil des Laufrahmens 31 bilden.

Liste der Bezugszeichen:

1 Boden
2 Seitenwand
3 Zwischenteil
4 winkelförmiger Ansatz
5 Distanzrohr
6 Zugstangen
7 rohrförmiger Ansatz
8 Kopf
9 Mutter
10 Hohlprofil
11 Vorsprung
12 Mittelschenkel
13 Laufrahmen
14 Rippe
15 Tasche
16 Führungsschiene
17 Nuten
18 Führungsschiene
19 Feststellschraube
20 Mutter
21 Langloch
22 Aussparung
23 Raststift
24 Feder
25 Schraube
26 Rippe
27 U-förmiger Vorsprung
28 Wand
29 Rippe
30 Taschen
31 Laufrahmen
32 Ausnehmung
33 Rippe
34 Haltewinkel
35 Lager
36 Support
37 Vorsprung
38 Linie
39 Tasche

**Patentansprüche**

1. Transport- und Lagervorrichtung für Leiterplatten,
bestehend aus einem Boden, zwei an diesem angebrachten Seitenwänden, mindestens einem an den Seitenwänden verschieb- und feststellbar angebrachten Zwischenteil und zwischen den Eckbereichen der Seitenwände angeordneten Distanzstangen und/oder Rohren,
von denen der Boden und die Zwischenteile auf den einander zugekehrten Seiten mit die Leiterplatten halternden Führungsschienen und auf den den Leiterplatten abgekehrten Seiten mit Verstärkungsrippen versehen sind,
wobei die Seitenwände mit Langlöchern parallel zu deren Rändern versehen sind, in denen an den Zwischenteilen angreifende Befestigungsmittel verschieb- und feststellbar angeordnet sind,
dadurch gekennzeichnet,
daß die Bodenplatte (1) und die Seitenwände (2) mit Verstärkungsrippen (10, 14) versehen sind, die in den Randbereichen nach innen, in den Mittenbereichen nach außen gerichtet sind, wodurch der Boden (1) und die Seitenwände (2) nach außen glatte Randbereiche als Laufrahmen (13,31) aufweisen, daß in den Ecken der Seitenwände (2) in den sonst glatten Randbereichen des Laufrahmens (31) Ausnehmungen (32) angeordnet sind, in denen Befestigungsmittel für die Distanzrohre (5) und Zugstangen (6) liegen, daß die Langlöcher (21) in den Mittenbereichen angeordnet sind, in denen die Rippen (33) nach außen gerichtet sind, und die Befestigungsmittel (19) für die Zwischenteile (3) eine geringere Höhe als die nach außen gerichteten Rippen (33) aufweisen, und daß die Zwischenteile (3) auf zwei gegenüberliegenden Stirnwänden, mit denen sie an den Seitenwänden anliegen, winkelförmige Ansätze (4) aufweisen, in denen Befestigungsmittel (19) für die Befestigung an den Seitenwänden (2) untergebracht sind.

2. Transport- und Lagervorrichtung nach Anspruch 1,
dadurch gekennzeichnet,
daß in den Seitenwänden (2) parallel zu deren Rändern verlaufende langgestreckte Vertiefungen als Führungsschienen (18) für an den winkelförmigen Ansätzen (4) ausgebildete Vorsprünge (17) geformt sind.

3. Transport- und Lagervorrichtung nach Anspruch 1,
dadurch gekennzeichnet,
daß in den Vertiefungen (18) kreis- oder rechteckförmige Ausnehmungen (28) für Rastkugeln oder -stifte (23) angeordnet sind, deren Halter in den winkelförmigen Ansätzen (4) eingebaut sind.

4. Transport- und Lagervorrichtung nach Anspruch 1,
dadurch gekennzeichnet,
daß das Zwischenteil (3) an demjenigen Rand, an dem die Führungsschienen (16) für die Leiterplatten nicht verschlossen sind, einen um ein Gelenk (35) klappbaren Haltewinkel (34) aufweist, der an seinen Stirnseiten einen rechtwinklig angeformten Ansatz (36) trägt, der ein Gelenkteil haltert.

5. Transport- und Lagervorrichtung nach Anspruch 4,
dadurch gekennzeichnet,
daß der Ansatz (36) an dem Haltewinkel (34) eine Ausnehmung aufweist, in die in der Haltestellung ein am Zwischenteil (3) befestigter federnder Vorsprung (37) oder Stift einfällt.

FIG.1

**FIG.2**

FIG.3

FIG.4

EP 0 472 843 A1

FIG. 5

# EUROPÄISCHER RECHERCHENBERICHT

Nummer der Anmeldung

**EP 91 11 0228**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | DE-A-3 801 966   (STUCKI KUNSTSTOFFWERK) <br> * Spalte 1, Zeile 51 - Spalte 2, Zeile 37; Spalte 3, Zeilen 4-46; Spalte 4, Zeilen 12-22; Figuren 1-3,9 * <br> – – – | 1-4 | H 05 K 13/00 |
| A | GB-A-2 148 831   (USM) <br> * Seite 1, Zeilen 95-109; Figur 1 * <br> – – – | 1 | |
| D,A | DE-U-8 903 430   (STUCKI KUNSTSTOFFWERK) <br> * Seite 4, Absatz 1; Seite 4, letzter Absatz - Seite 5, Absatz 2; Seite 6, Absatz 2; Figuren 1,2 * <br> – – – | 1 | |
| A | WO-A-8 403 411   (MENASHA) <br> * Seite 3, Zeilen 17-25; Seite 4, Zeilen 11-13; Figur 1 * <br> – – – – – | 1 | |

| RECHERCHIERTE SACHGEBIETE (Int. Cl.5) |
|---|
| H 05 K 13/00 <br> H 05 K 5/00 <br> B 65 D 1/00 <br> B 65 D 21/00 <br> B 65 D 85/00 |

Der vorliegende Recherchenbericht wurde für alle Patentansprüche erstellt

| Recherchenort | Abschlußdatum der Recherche | Prüfer |
|---|---|---|
| Berlin | 21 November 91 | ALEXATOS G |